(19) Europäisches Patentamt / European Patent Office / Office européen des brevets

(11) **EP 4 708 690 A1**

(12) **EUROPEAN PATENT APPLICATION**
published in accordance with Art. 153(4) EPC

(43) Date of publication:
**11.03.2026 Bulletin 2026/11**

(21) Application number: **24884165.2**

(22) Date of filing: **22.08.2024**

(51) International Patent Classification (IPC):
*H03H 17/02* *(2006.01)*

(52) Cooperative Patent Classification (CPC):
**H03H 17/02**

(86) International application number:
**PCT/CN2024/114062**

(87) International publication number:
**WO 2025/092158 (08.05.2025 Gazette 2025/19)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **30.10.2023 CN 202311425949**

(71) Applicant: **Actions Technology Co., Ltd.
Zhuhai, Guangdong 519085 (CN)**

(72) Inventor: **LI, Xinhui
Zhuhai, Guangdong 519085 (CN)**

(74) Representative: **Ipsilon
12, avenue d'Italie
75013 Paris (FR)**

(54) **IIR FILTER DEVICE AND FILTERING METHOD THEREOF**

(57)      Disclosed in the present application are an IIR filter device and a filtering method thereof. The IIR filter device comprises: a head data module, which stores current input data and two pieces of input historical data; a filtering module, which stores output data of each stage via an intermediate data module first position corresponding to each stage of filtering, switches the addresses of the first position and a second position and, via a calculation module, reads the current input data and the two pieces of input historical data from a designated position, reads two pieces of output historical data from an intermediate data module and stores said data in a tail data module, and after filtering, outputs data and triggers the next stage of filtering; and the tail data module, which is used, when any stage of filtering is complete, for storing the output data of said stage of filtering as input data for the next stage of filtering, the designated position of a first stage of filtering being the head data module, and the designated position of the other stages of filtering being the tail data module. The application reduces data read and write times, avoids interruption of the calculation pipeline, reduces the required data storage by half, and reduces the required clock frequency.

FIG. 4

**Description**

**Cross-Reference to Related Applications**

This application claims priority to Chinese Patent Application No. 202311425949.1, filed with the China National Intellectual Property Administration on October 30, 2023 and entitled "IIR Filter Device and Filtering Method thereof", both of which are hereby incorporated by reference in their entireties.

**Technical Field**

The application relates to the field of filter technology, in particular to an IIR filter device and filtering method thereof.

**Background**

An Infinite Impulse Response (IIR) filter device is a type of digital filter, and based on the filtering method, the output signal is weighted combination of previous input signal(s) and output signal(s).

Excessively high-order IIR filters are unstable, generally, high-order IIR filters are decomposed into a cascade of multiple biquad IIR filters. Each biquad IIR stage is referred to as a section.

For a biquad IIR, each section requires storing and reading a current input data value, two historical input data values, and two historical input data values. Thus, for an N-section cascaded biquad IIR filter operating in a serial computation mode, the conventional implementation requires a Random Access Memory (RAM) capacity of 5*N words. Since reading and writing the historical input and output values of a current section are required at intermediate stages, a total computation time requires 10*N clock cycles. Consequently, the required clock frequency must be greater than 10*N times the sampling rate. For a fixed sampling rate, the relatively high clock frequency leads to increased cost and power consumption.

**Summary**

This application provides an IIR filter device and its filtering method, aiming to address issues in existing IIR filters of requiring large RAM space, long read/write times, and a relatively high clock frequency.

In a first aspect, embodiments of the application provide an IIR filter device, including a header data module, a filtering module, and a tail data module. The header data module is configured, to receive a current input data value, and to latch the current input data value by overwriting an earliest historical input data value, maintaining that the current input data value and two historical input data values are stored. The filtering module is configured, to perform multi-stage filtering calculations, and includes an intermediate data module and a calculation module. The intermediate data module includes a first location and a second location corresponding to each stage of filtering, and is configured to use the first location corresponding to each stage of filtering to store an output data value of that stage of filtering, and to exchange an address of the first location and an address of the second location. The calculation module is configured, based on determining that a current stage of filtering is triggered, to read the current input data value and two historical input data values from a specified location, to read data values from a first location and a second location corresponding to the current stage of filtering in the intermediate data module as two historical output data values, to store the two historical output data values into the tail data module as two historical input data values for a next stage of filtering, to obtain a current output data value after filtering, and to trigger the next stage of filtering. The tail data module is configured, to store the two historical output data values read by the calculation module as two historical input data values, and, upon completion of any stage of filtering, to store an output data value of that stage as the current input data value for the next stage of filtering. Here, a specified location for a first stage of filtering is the header data module, and a specified location for another stage of filtering is the tail data module.

In some possible embodiments, the header data module includes a header data register and a header data manager. The header data register includes a first header register, a second header register, and a third header register. The header data manager is configured, to receive the current input data value, to latch a historical input data value from the first header register into the second header register/the third header register where the earliest historical input data value is stored, and to latch the current input data value into the first header register.

In some possible embodiments, the header data register further includes a status register. The header data manager is configured, after the first stage of filtering is completed, to trigger a change in a status value of the status register. Here, based on that the status value is a first status value, the historical input data value from the first register is latched into the second register, and based on that the status value is a second status value, the historical input data from the first register is latched into the third register.

In some possible embodiments, the intermediate data module includes: an intermediate data manager and an intermediate data memory. The intermediate data manager is configured to store an output data value of each stage of filtering into the first location and exchange the address of the first location and the address of the second location. The intermediate data memory includes a first address and a second address corresponding to each stage of filtering. Here, the first address and the second address are used to store corresponding data.

In some possible embodiments, the calculation module includes a data selector, a coefficient memory and a multiply-accumulate unit. The data selector is configured, when the current stage of filtering is triggered, to read the current input data value and two historical input data values from the specified location, to read data values from the first location and the second location corresponding to the current stage of filtering in the intermediate data module as two historical output data values, to read coefficients corresponding respectively to the current input data value, the two historical input data values, and the two historical output data values from the coefficient memory, and to output the read data values and the corresponding coefficients to the multiply-accumulate unit. The coefficient memory is configured to store the coefficients corresponding to the current input data value, two historical input data values, and two historical output data values for each stage of filtering. The multiply-accumulate unit is configured to perform multiply-accumulate operations based on the current input data value, two historical input data values, two historical output data values, and the coefficients corresponding respectively to the current input data value, two historical input data values, two historical output data values to obtain the current output data value.

In some possible embodiments, the calculation module further includes an output latch, connected to the multiply-accumulate unit and configured to latch the current output data value.

In some possible embodiments, the tail data module includes a tail data manager and a tail data register. The tail data register includes a first tail register, a second tail register, and a third tail register. The tail data manager is configured: during calculation of the current stage of filtering, to latch a historical output data value read by the calculation module from the first location corresponding to the current stage of filtering in the intermediate data module into the second tail register, and to latch a historical output data value read from the second location corresponding to the current stage of filtering in the intermediate data module into the third tail register; and upon completion of the current stage of filtering, to latch the output data value of the current stage of filtering into the first tail register.

In some possible embodiments, the device further includes: a clock cycle counter and a section counter. The clock cycle counter is configured, to start counting when any stage of filtering is triggered. Each time a clock cycle count value increases by one, a corresponding one of parameter sets is read. The parameter sets include: the current input data value and a coefficient corresponding to the current input data value, the first historical input data value and a coefficient corresponding to the first historical input data value, the second historical input data value and a coefficient corresponding to the second historical input data value, the first historical output data value and a coefficient corresponding to the first historical output data value, and the second historical output data value and a coefficient corresponding to the second historical output data value. The clock cycle count value is reset to zero based on determining that the current stage of filtering is completed. The section counter is configured, to increase a section count value by one upon completion of any stage of filtering; based on that the section count value reaches a set section number, to determine that all stages of filtering are completed, and to reset the section count value to zero.

In a second aspect, embodiments of the application provide a filtering method of an IIR filter device, including: using a header data module to receive a current input data value and latch the current input data value by overwriting an earliest historical input data value, maintaining that the current input data value and two historical input data values are stored in the header data module; triggering a first stage of filtering, reading the current input data value and two historical input data values from the header data module for filtering, and reading two historical output data values from a first location and a second location corresponding to the first stage of filtering in the intermediate data module for filtering; determining to trigger another stage of filtering, reading a current input data value and two historical input data values from a tail data module, reading two historical output data values from a first location and a second location corresponding to that stage of filtering in the intermediate data module for filtering, and storing the two historical output data values into the tail storage module as two historical input data values for a next stage of filtering; and based on determining that any stage of filtering is completed, using the tail data module to store an output data value of that stage of filtering as a current input data value for the next stage of filtering; and triggering the next stage of filtering until filtering is completed.

In some possible embodiments, the method further includes: starting counting when any stage of filtering is triggered; reading a corresponding one of parameter sets each time a clock cycle count value increases by one, where the parameter sets includes: the current input data value and a coefficient corresponding to the current input data value, the first historical input data value and a coefficient corresponding to the first historical input data value, the second historical input data value and a coefficient corresponding to the second historical input data value, the first historical output data value and a coefficient corresponding to the first historical output data value, and the second historical output data value and a coefficient corresponding to the second historical output data value; resetting the clock cycle count value to zero based on determining that the current stage of filtering is completed; increasing the section count value by one upon completion of any stage of filtering, based on that the section count value reaches a set section number, determining that all stages of filtering are completed, and resetting the section count value to zero.

In some possible embodiments, the corresponding one of parameter sets is read in a following order: the second historical input data value and the coefficient corresponding to the second historical input data value, the current input data value and the coefficient corresponding to the current input data value, the first historical output data value and the coefficient corresponding to the first historical output data value, the first historical input data value and the coefficient corresponding to the first historical input data value, the second historical output data value and the coefficient corresponding to the second historical output data value. Here, the first historical input data value precedes the second historical input data value, and the first historical output data value precedes the second historical output data value.

The IIR filter device provided by the embodiments of the application introduces a header data module, an intermediate data module, and a tail data module. It uses address exchange to replace multiple data read/write operations, allowing the intermediate results of calculations to be communicated section by section within registers without storing intermediate results in RAM. This reduces the time required for reading from and writing to RAM and avoids interrupting the calculation flow. Compared to conventional serial computation direct Form I IIR filters, the required RAM space for data storage is reduced by half, and the required clock frequency is lowered by more than 40%.

Other features and advantages of the application will be set forth in the subsequent description, and partly will become apparent from the description, or may be understood through the implementation of the application. The objectives and other advantages of the application may be realized and attained by the structure particularly pointed out in the written description, claims, and drawings.

**Brief Description of Figures**

To more clearly illustrate the technical solutions in the embodiments of the application, the drawings required for describing the embodiments are briefly introduced below. Obviously, the drawings described below are merely some embodiments of the application. For those of ordinary skill in the art, other drawings may be obtained based on these drawings without creative efforts.

FIG. 1 is a schematic diagram of a lattice structure of a Direct Form I IIR filter.
FIG. 2 is a schematic diagram of a multi-stage biquad IIR filter cascade.
FIG. 3 is a schematic diagram of a lattice structure of a Direct Form I biquad IIR.
FIG. 4 is a schematic structural diagram of an IIR filter device according to embodiments of the application.
FIG. 5A is a schematic structural diagram of a first-stage filter performing filtering calculation according to embodiments of the application.
FIG. 5B is a schematic structural diagram of other-stage filter performing filtering calculation according to embodiments of the application.
FIG. 6 is a schematic diagram illustrating the operation of a header data manager according to embodiments of the application.
FIG. 7 is a schematic diagram illustrating data storage through address exchange in an intermediate data memory according to embodiments of the application.
FIG. 8 is a schematic diagram illustrating a filtering calculation process for other-stage filter according to embodiments of the application.
FIG. 9 is an overall flowchart illustrating the operation based on a clock cycle counter and a section counter according to embodiments of the application.
FIG. 10 is a flowchart of a filtering method of an IIR filter device according to embodiments of the application.
FIG. 11 is a schematic diagram illustrating a filtering calculation process for other-stage filters according to another embodiment of the application.
FIG. 12 is an overall flowchart illustrating the operation based on a clock cycle counter and a section counter according to another embodiment of the application.

**Detailed Description**

To further illustrate the technical solutions provided by the embodiments of the application, a detailed description is given below in conjunction with the accompanying drawings and specific implementations. Although the embodiments of the application provide method operation steps as shown in the following embodiments or drawings, the method may include more or fewer operation steps based on conventional or non-creative efforts. For steps without a necessary logical causal relationship, the execution order of these steps is not limited to the order provided in the embodiments of the application. In actual processing or when executed by control device, the method may be executed sequentially or in parallel according to the order shown in the embodiments or the drawings.

In the time-domain, IIR is expressed as follows:

$$y(n) = -\sum_{k=1}^{N} a_k y(n-k) + \sum_{k=0}^{M} b_k x(n-k) \qquad (1).$$

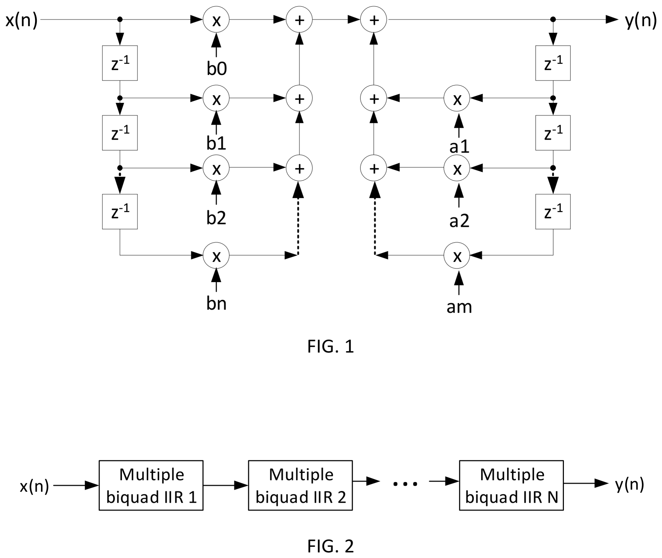

The lattice structure of a Direct Form I IIR filter is shown in FIG. 1.

Excessively high-order IIR filters are unstable. Generally, high-order IIR filters are decomposed into a cascade of multiple biquad IIR filters, as shown in FIG. 2.

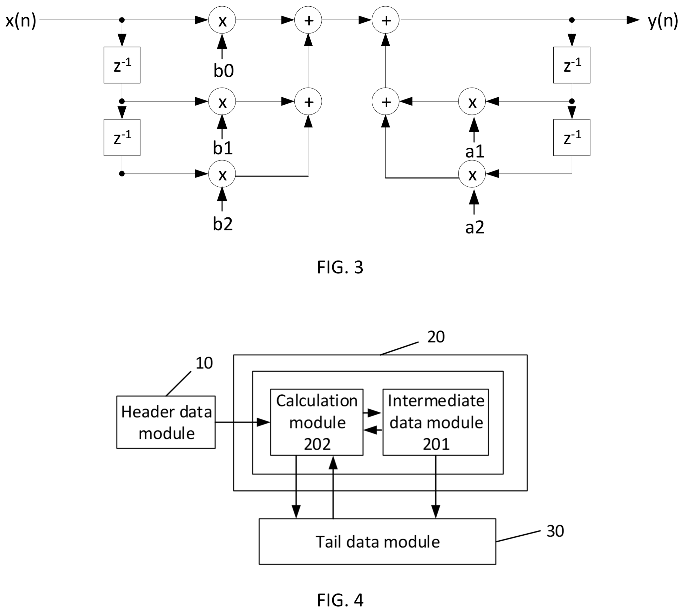

Each biquad IIR filter stage is referred to as a section. The lattice structure of a single Direct Form I biquad IIR filter section is shown in FIG. 3.

For a biquad IIR filter, each section requires storing and reading the current input data, two historical input data values, and two historical output data values. Thus, for an N-section cascaded biquad IIR filter operating in serial computation mode, the conventional implementation requires a RAM capacity of 5*N words. Since reading and writing the historical input and output values of the current section are required at intermediate stages, the total computation time requires 10*N clock cycles. Consequently, the required clock frequency must be greater than 10*N times the sampling rate. For a fixed sampling rate, the relatively high clock frequency leads to increased cost and power consumption.

In view of this, the application provides an IIR filter device. Although the IIR filter device still belongs to the cascaded Direct Form I biquad IIR type, it reduces RAM usage and lowers the required clock frequency by optimizing data access methods and adjusting calculation steps.

Other features and advantages of the application will be set forth in the subsequent description, and partly will become apparent from the description, or may be understood through the implementation of the application. The objectives and other advantages of the application may be realized and attained by the structure particularly pointed out in the written description, claims, and drawings.

The IIR filter device and its filtering method in the embodiments of the application are described in detail below with reference to the drawings.

Embodiments of the application provide an IIR filter device, as shown in FIG. 4, including a header data module 10, a filtering module 20, and a tail data module 30.

The header data module 10 is configured to receive a current input data value, latch the current input data by overwriting an earliest historical input data value, and maintain storage of the current input data value and two historical input data values.

That is, the header data module utilizes three storage locations. Each time a new data value is input, if there is free space in the three storage locations, the data can be stored in the free location. If all three locations contain data, the earliest historical data value can be overwritten. This ensures the header data module always stores the current input data value and the two latest historical input data values.

The filtering module 20 is configured to perform multi-stage filtering calculations. Each stage of filter includes an intermediate data module 201 and a calculation module 202. The intermediate data module 201 includes a first location and a second location corresponding to each stage of filtering. The first location corresponding to each stage of filtering is used to store an output data value of that stage, and then addresses of the first and second locations are exchanged. Upon determining that the current-stage filtering is triggered, the calculation module reads the current input data value and two historical input data values from specified locations, reads the data values from the first and second locations corresponding to the current-stage filtering in the intermediate data module as two historical output data values, stores the two historical output data values into the tail data module as two historical input data values for a next-stage filtering, obtains the current output data value after filtering, and triggers the next-stage filtering. The aforementioned calculation module 202 is used to realize the function of multi-stage cascaded filters. The cascaded filters are Direct Form I biquad IIR filters. After completing one stage of filtering, the newly calculated output data value is stored in the first location corresponding to that stage. However, after storage, the addresses of the first and second locations are exchanged, using two addresses to alternately store output data values. Thus, when filtering calculation is triggered, the two latest historical output data values are stored in the two addresses.

The calculation module 202 is configured, after a new data value is input, to trigger the first stage of filtering calculation, and according to the cascade order, upon completion of each stage's filtering calculation, to trigger a next stage's filtering calculation. After the final stage's filtering calculation is completed, a new data value is input to the first stage to begin the next serial filtering calculation. The calculation module 202 requires the current input data value, two historical input data values, and two historical output data values for filtering calculations at each stage. In embodiments of the application, the current input data value is labeled x0, a previous historical input data value is labeled x1, a historical input data value before that is labeled x2, a previous historical output data value is labeled y1, and a historical output data value before that is labeled y2.

The tail data module 30 is configured, to store the two historical output data values read by the calculation module as two historical input data values, and, upon completion of any stage' filtering calculation, to store an output data value of that stage as a current input data value for the next-stage filtering.

In the embodiments of the application, the data always stored by the tail data module are: the two historical input data values and the current input data value for the next-stage filtering. Specific storage methods are described above.

Here, the specified location for the first stage of filtering is the header data module, and the specified location for other-stage filtering is the tail data module.

In the embodiments of the application, a header data module, an intermediate data module, and a tail data module are introduced. The intermediate data module uses address exchange to replace multiple data read/write operations. The tail data module always stores the current output data value currently calculated and two historical output data values, using them as input for the next section's filtering calculation. This allows the intermediate results of calculations to be communicated section by section within registers without storing intermediate results in RAM, reducing the time required for reading from and writing to RAM and avoiding interruption of the calculation. Compared to conventional serial computation Direct Form I IIR filters, the required RAM for data storage is reduced by half, and the required clock frequency is lowered by more than 40%.

The aforementioned header data module 10 is used to provide x0, x1, and x2 for the first stage of filtering. The tail data module 30 is used to provide x0, x1, and x2 for the next-stage filtering after the current filtering is completed.

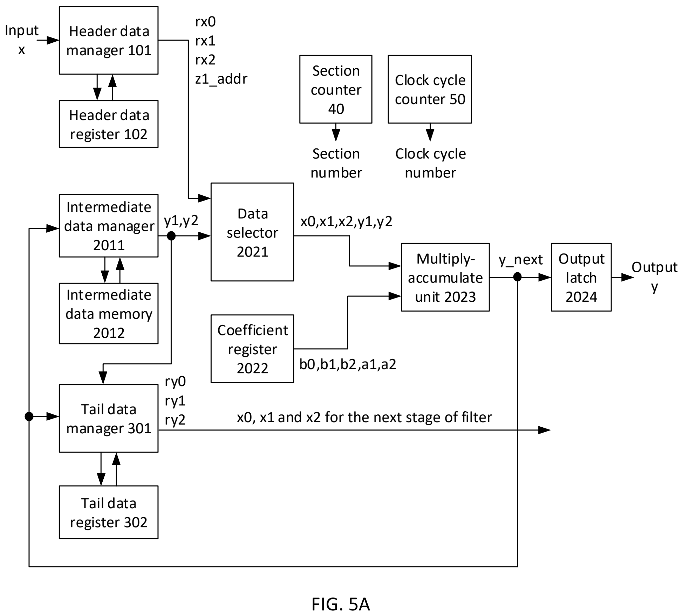

The header data module 10 is used to store and manage the current input data value x0 and the two historical input data values x1, x2 for the first stage of filtering. As shown in FIG. 5A, the header data module 10 includes a header data manager 101 and a header data register 102.

The header data manager 101 is configured to receive the current input data value x0, latch the historical input data value from the first header register rx0 into the second header register rx1 or the third header register rx2 where the earliest historical input data value is stored, and latch the current input data value x0 into the first header register rx0. Thus, when x0 arrives, the data value previously latched in rx0 is moved as x1 to rx1 or rx2, overwriting the earliest historical input data value, while the data value latched in the other register (rx2 or rx1) remains as x2, ensuring that x0, x1, and x2 are always stored and held.

The header data register 102 includes a first header register rx0, a second header register rx1, and a third header register rx2.

In the embodiment of the application, the header data register 102 further includes a status register z1_addr.

The header data manager 101 is configured, after the completion of the first stage of filtering, to trigger a change in a status value of the status register z1_addr.

Here, when the status value is a first status value, the historical input data value in the first register rx0 is latched into the second register rx1; when the status value is a second status value, the historical input data value in the first register rx0 is latched into the third register rx2. The first status value can be 0 and the second status value 1; or the first status value can be 1 and the second status value 0.

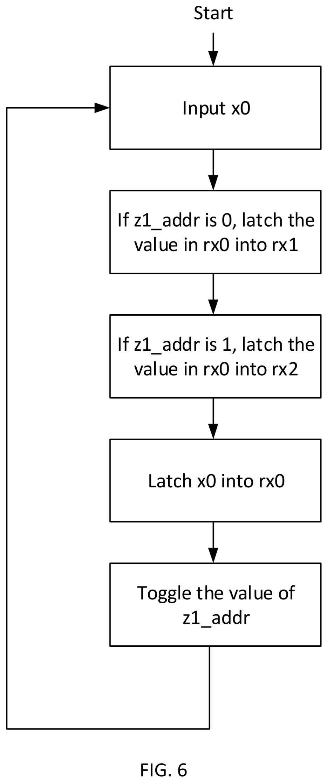

FIG. 6 shows the data storage flowchart of the header data management module. When input data value x0 is entered, if z1_addr is 0, the value in rx0 is latched into rx1; if z1_addr is 1, the value in rx0 is latched into rx2. Then, x0 is latched into rx0, and then the status value of z1_addr is toggled.

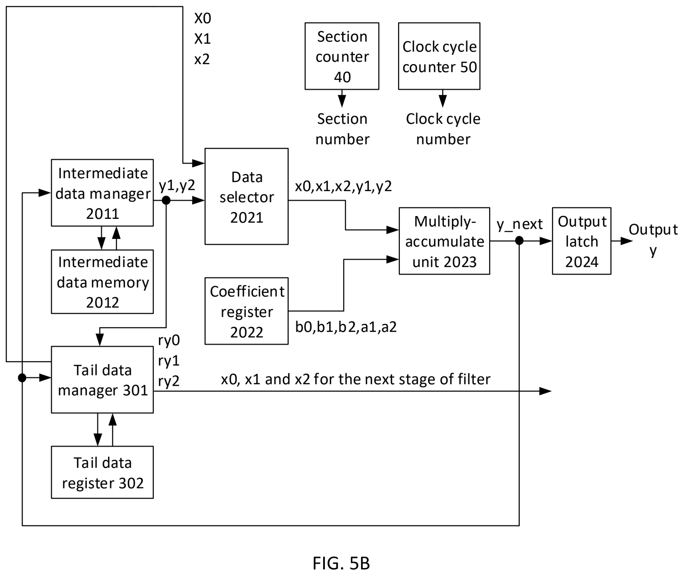

The intermediate data module 201 is used to store and manage intermediate historical data value(s). As shown in FIG. 5A and FIG. 5B, in the embodiment of the application, the intermediate data module 201 includes an intermediate data manager 2011 and an intermediate data memory 2012.

The intermediate data manager 2011 stores the output data value of each stage of filtering into the first location (location y1) corresponding to that stage, and exchanges the addresses of the first location (y1) and the second location (y2).

The intermediate data memory 2012 includes a first address and a second address corresponding to each stage of filtering. The first address and second address are used to store the corresponding data.

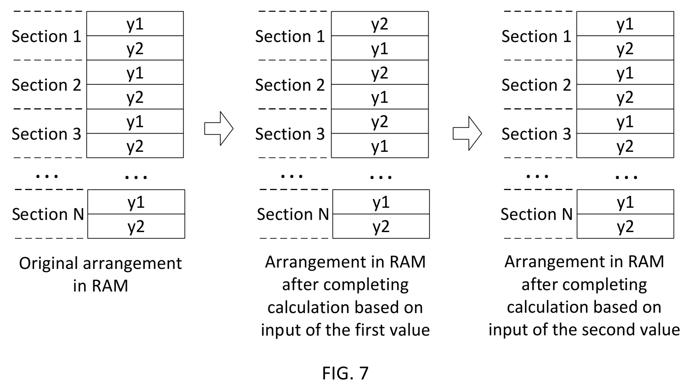

In the embodiments of the application, the calculation module realizes the function of an IIR filter. The IIR filter is composed of N sections of biquad IIR filters connected in series. Each biquad IIR filter corresponds to an intermediate data memory in the intermediate data module, where N is the number of cascaded sections of the IIR filter. As shown in FIG. 7, the N intermediate data memories form a RAM with a depth of 2*N. After the filtering calculation of each biquad IIR filter section is completed, the current output data value y_next is stored in the location y1 of the intermediate data memory for this section. After storage, the addresses of the location y1 and location y2 for this section are exchanged.

The tail data module 30 is used to store and manage the current output data value and two historical output data values for each section, serving as a current input data value and two historical input data values for the next section. This allows historical data values to be communicated through each section, saving RAM space and the clock cycles required for reading from and writing to RAM. As shown in FIG. 5A and FIG. 5B, the tail data module 30 includes a tail data manager 301 and a tail data register 302.

The tail data manager 301 is configured, during the filtering calculation of the current stage, to latch the historical output data value y1, read by the calculation module 202 from the first location corresponding to the current stage of filtering in the intermediate data module 201, into the second tail register ry1; to latch the historical output data value y2, read from the second location corresponding to the current stage of filtering in the intermediate data module 201, into the third tail register ry2; and upon completion of the current stage of filtering, to latch the output data value y_next of the current stage of filtering into the first tail register ry0.

The tail data register 302 includes a first tail register ry0, a second tail register ry1, and a third tail register ry2.

Upon completion of each section's calculation, the output result y_next of this section is stored in register ry0, which provides the input data value x0 required for the next section's calculation.

During the calculation of each section, the historical data values y1 and y2 are obtained from the intermediate data memory. While these two data values are used for calculation, they are also latched into ry1 and ry2, respectively, serving as x1 and x2 required for the next section's calculation.

Through the tail data manager 301 and the tail data register 302, the historical data values x0, x1, and x2 that originally needed to be stored separately for each section no longer require independent storage. Instead, they are communicated sequentially between sections via the tail data register 302, thereby saving RAM space and, more the clock cycles needed for reading from and writing to RAM.

The calculation module 202 in the embodiments of the application is used for performing multi-stage filtering calculations. As shown in FIG. 5A and FIG. 5B, the calculation module 202 includes a data selector 2021, a coefficient memory 2022 and a multiply-accumulate unit (MAC) 2023.

The data selector 2021 is configured, when the current stage of filtering is triggered, to read the current input data value x0 and two historical input data values x1, x2 from a specified location; to read two historical output data values y1 and y2 from the first and second locations corresponding to the current stage of filtering in the intermediate data module, to read coefficients b0, b1, b2, a1, a2 corresponding to the current input data value x0, the two historical input data values x1, x2, and the two historical output data values y1, y2 respectively from the coefficient memory 2022, and to output x0, x1, x2, y1 and y2, and the coefficients b0, b1, b2, a1, a2 to the multiply-accumulate unit (MAC) 2023.

FIG. 5A shows the structural diagram corresponding to the first-stage filtering calculation. The data selector 2021 reads x0, x1, x2 from registers rx0, rx1, and rx2. The intermediate data manager 2011 reads y1, y2 from the intermediate data memory 2012 and sends them to the data selector 2021.

FIG. 5B shows the structural diagram corresponding to filtering calculations for stages other than the first stage. The tail manager 301 reads data from ry0, ry1, and ry2 in the tail data register 302 to obtain x0, x1, x2 and sends them to the data selector 2021. The intermediate data manager 2011 reads y1, y2 from the intermediate data memory 2012 and sends them to the data selector 2021.

The coefficient memory 2022 is configured, to store the coefficients b0, b1, b2, a1, a2 corresponding to the current input data value x0, the two historical input data values x1, x2, and the two historical output data values y1, y2 for each stage of filtering.

The multiply-accumulate unit (MAC) 2023 is configured, to perform multiply-accumulate operations based on the current input data value x0, the two historical input data values x1, x2, the two historical output data values y1, y2, and their corresponding coefficients b0, b1, b2, a1, a2, to obtain the current output data value. The specific calculation formula is as follows:

$$ACC = ACC + C * D \qquad (2).$$

Here, ACC is the accumulated value of the MAC, D represents the current input data value x0, the two historical input data values x1, x2, and the two historical output data values y1, y2, respectively, and C represents the coefficients. The coefficients C corresponding to D are b0, b1, b2, a1, a2, respectively. The MAC 2023 accumulates, based on the previously obtained accumulated value, the product of the coefficient sequence (b0, b1, b2, a1, a2) and the corresponding data sequence (x0, x1, x2, y1, y2).

Optionally, the calculation module 202 further includes: an output latch 2024, connected to the MAC, and configured to latch the current output data value y_next.

Thus, upon completion of a section's calculation, the tail data manager 301 reads the current output data value y_next from the output latch 2024, interacts with the intermediate data manager 2011, and reads y1, y2 from the intermediate data memory 2012 and writes them into ry1, ry2.

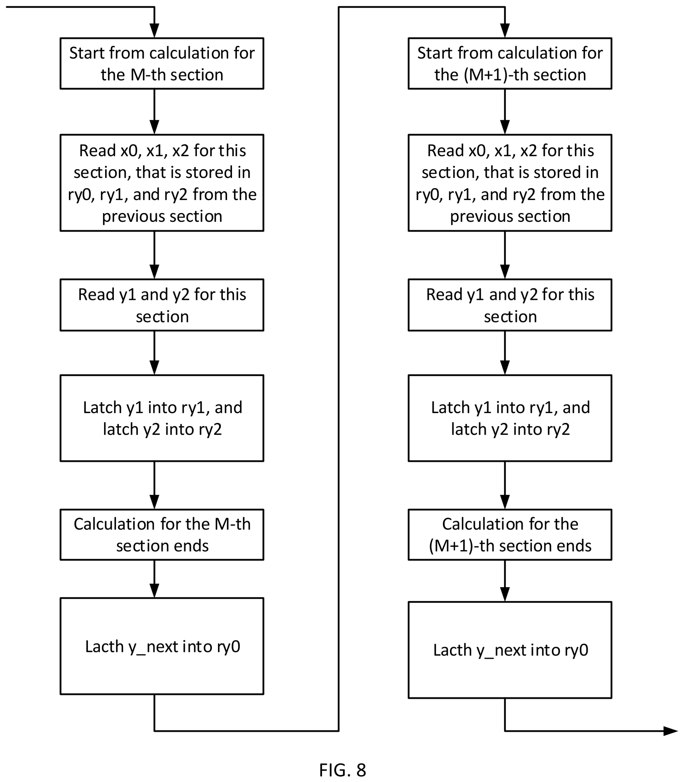

As shown in FIG. 8, for the calculation module, starting from the calculation for the M-th section, x0, x1, x2 for this section are read in the manner described above-that is, the y_next, y1, y2 stored in ry0, ry1, and ry2 from the previous section. Data values y1 and y2 for this section are read in the manner described above. y1 is latched into ry1, and y2 is latched into ry2. The MAC begins calculation. At the end of the calculation, y_next is latched into ry0. The calculation for the (M+1)-th section is triggered, following the same process, which will not be repeated here.

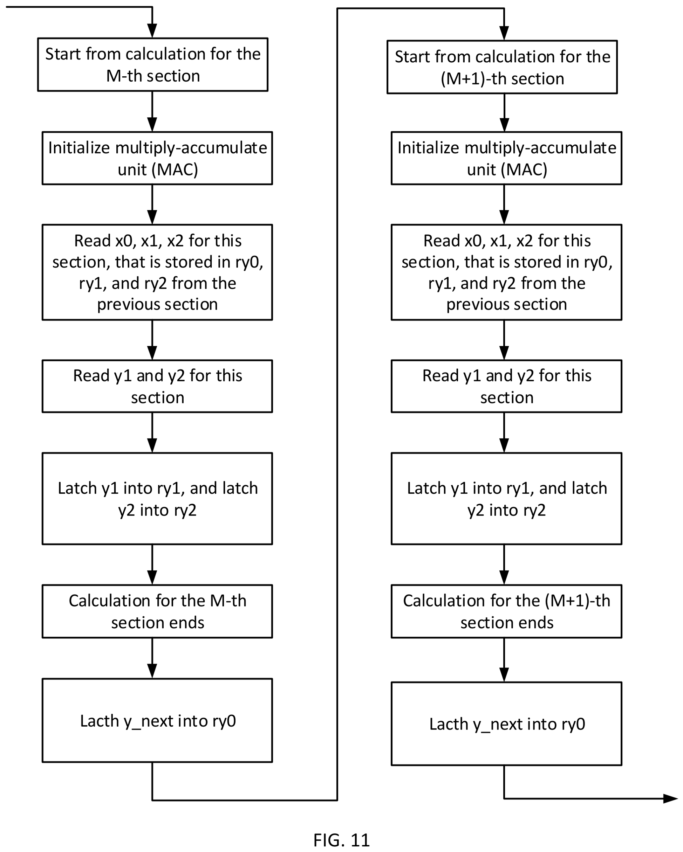

FIG. 11 is a schematic diagram of the filtering calculation process for other-stage filters in another embodiment of the application. Compared to the calculation process shown in FIG. 8, starting from calculation for the M-th section, the MAC is further initialized; when the calculation for the (M+1)-th section is triggered, the MAC is further initialized. The rest of the calculation process is the same as that shown in FIG. 8 and will not be repeated here.

As shown in FIG. 5A and FIG. 5B, the IIR filter device further includes a clock cycle counter 50 and a section counter 40.

7

A clock cycle counter 50 is configured, to start counting while filtering. Each time the clock cycle count value increases by one, a corresponding one of parameter sets is read. The parameter sets include: the current input data value x0 and its corresponding coefficient, the first historical input data value x1 and its corresponding coefficient, the second historical input data value x2 and its corresponding coefficient, the first historical output data value y1 and its corresponding coefficient, and the second historical output data value y2 and its corresponding coefficient. The clock cycle count value is reset to zero when the current stage of filtering is determined to be completed. A set clock cycle number for the clock cycle counter is 5. Thus, by having the clock cycle count value cycle through 0, 1, 2, 3, 4, counting over 5 clock cycles is achieved. The data selector 2021 can read one data value and its corresponding coefficient per clock cycle according to the count, completing the data reading for x0, x1, x2, y1, y2 and their corresponding coefficients b0, b1, b2, a1, a2.

The section counter 40 is configured, to increase the section count value by one upon completion of any stage of filtering. When the section count value reaches a set section number, it is determined that all stages of filtering are completed, and the section count value is reset to zero. When the clock cycle counter counts the set clock cycle number, the section count value increases by one. It is reset to zero when the set section number, which is N, is reached. That is, every 5 clock cycles, the ACC outputs the result y_next value for the current section. After all sections have completed their operations, the final result is latched by the output latch and output.

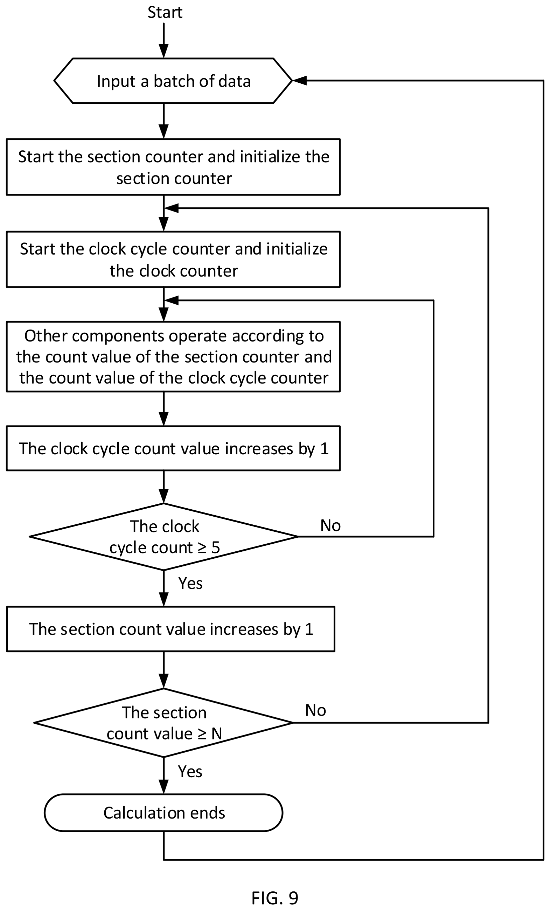

Through the section counter 40 and the clock cycle counter 50, control during the calculation process can be achieved. The header data manager, intermediate data manager, and tail data manager perform data reading and latching based on the count values of the clock cycle counter and the section counter. The specific workflow is shown in FIG. 9:

input a batch of data;
start the section counter and initialize the section counter;
start the clock cycle counter and initialize the clock counter;
other components operate according to the count value of the section counter and the count value of the clock cycle counter;
the clock cycle count value increases by 1, and one data value from x0, x1, x2, y1, y2 and its corresponding coefficient are read;
determine if the clock cycle count is greater than or equal to 5 based on the count value;
if the clock cycle count reaches 5, it indicates that x0, x1, x2, y1, y2 and their corresponding coefficients b0, b1, b2, a1, a2 have been completely read. Multiply-accumulate operations are performed using x0, x1, x2, y1, y2 and their corresponding coefficients b0, b1, b2, a1, a2. After the calculation is completed, the section count value increases by 1. If the clock cycle count has not reached 5, return to the step where other components operate according to the count value of the section counter and the count value of the clock cycle counter;
determine if the section count value is greater than or equal to N; and
if the section count value reaches N, it indicates that N stages of filtering are completed, and this filtering calculation ends. If the section count value has not reached N, start the clock cycle counter, initialize it, and begin the filtering calculation for the next stage.

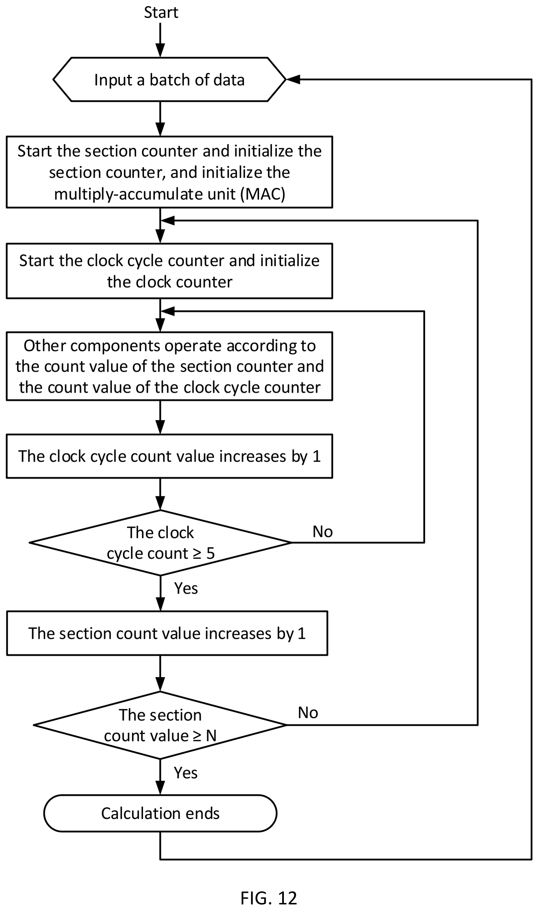

In another embodiment, as shown in FIG. 12, the overall workflow according to the clock cycle counter and the section counter, compared to the workflow shown in FIG. 9, additionally includes initializing the multiply-accumulate unit (MAC) when starting the section counter and initializing it. The rest of the workflow is the same and will not be repeated here.

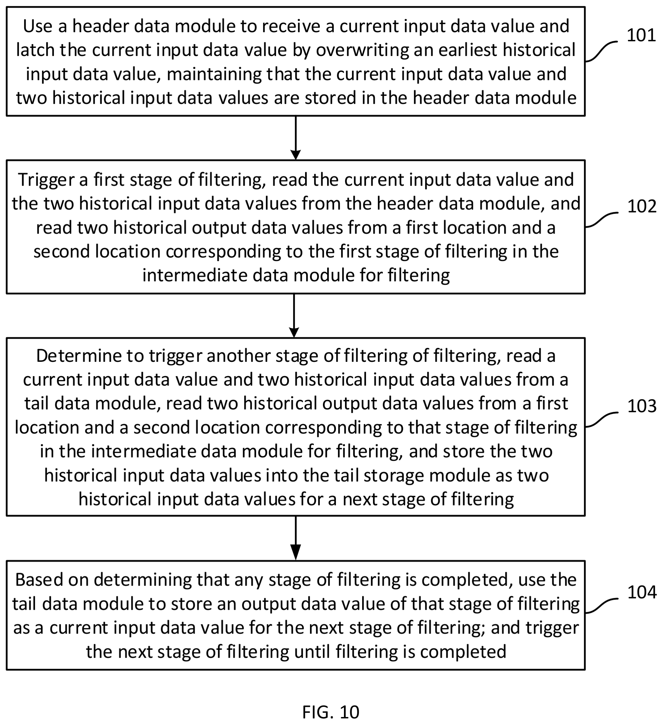

Embodiments of the application also provide a filtering method of an IIR filter device, as shown in FIG. 10, including:

step 101: use a header data module to receive a current input data value and latch the current input data value by overwriting an earliest historical input data value, maintaining that the current input data value and two historical input data values are stored in the header data module;
step 102: trigger a first stage of filtering, read the current input data value and the two historical input data values from the header data module for filtering, and read two historical output data values from a first location and a second location corresponding to the first stage of filtering in the intermediate data module for filtering;
step 103: determine to trigger another stage of filtering of filtering, read a current input data value and two historical input data values from a tail data module for filtering, read two historical output data values from a first location and a second location corresponding to that stage of filtering in the intermediate data module for filtering, and store the two historical input data values into the tail storage module as two historical input data values for a next stage of filtering; and
step 104: based on determining that any stage of filtering is completed, use the tail data module to store an output data value of that stage of filtering as a current input data value for the next stage of filtering; and trigger the next stage of filtering until filtering is completed.

As an optional implementation, start counting when any stage of filtering is triggered. Each time the clock cycle count value increases by one, a corresponding one of parameter sets is read. The parameter sets include: the current input data value and a coefficient corresponding to the current input data value, the first historical input data value and a coefficient corresponding to the first historical input data value, the second historical input data value and a coefficient corresponding to the second historical input data value, the first historical output data value and a coefficient corresponding to the first historical output data value, and the second historical output data value and a coefficient corresponding to the second historical output data value;

reset the clock cycle count value to zero when the current stage of filtering is determined to be completed;

increase the section count value by one based on determining that any stage of filtering is completed. When the section count value reaches a set section number, determine that all stages of filtering are completed, and reset the section count value to zero.

In the embodiments of the application, one of parameter sets is read correspondingly in the following order: the second historical input data value x2 and the coefficient b2, the current input data value x0 and the coefficient b0, the first historical output data value y1 and the coefficient a1, the first historical input data value x1 and the coefficient b1, the second historical output data value y2 and the coefficient a2.

The specific rules for the data selector to choose data are shown in Table 1.

Table 1

| Section count value | Clock cycle count value | Data value for choose | Equivalent output value |
|---|---|---|---|
| 0 | 0 | rx2 | x2 |
| | 1 | rx0 | x0 |
| | 2 | y1 | y1 |
| | 3 | rx1 | x1 |
| | 4 | y2 | y2 |
| k | 0 | ry2 | x2 |
| | 1 | ry0 | x0 |
| | 2 | y1 | y1 |
| | 3 | ry1 | x1 |
| | 4 | y2 | y2 |

The coefficient memory stores all IIR coefficients. The output coefficients according to the values of the clock cycle counter and the section counter, as shown in Table 2.

Table 2

| Section count value | Clock cycle count value | Outputs coefficient |
|---|---|---|
| k | 0 | b2 (for (k-1)th section) |
| | 1 | b0 (for (k-1)th section) |
| | 2 | a1 |
| | 3 | b1 |
| | 4 | a2 |

By following the data reading order specified in Table 1 and Table 2 can conflicts in data read/write and coefficient reading be avoided, completing all data read/write operations within 5 clock cycles. This prevents idle cycles in the data memory and calculation module during data read/write, thereby reducing the required clock speed.

Although preferred embodiments of the disclosure have been described, those skilled in the art will be able to make further changes and modifications to these embodiments once the basic inventive concepts are understood. Therefore, the appended claims are intended to be interpreted as including the preferred embodiments and all changes and modifications falling within the scope of the disclosure.

Apparently, those skilled in the art can make various changes and modifications to the embodiments without departing from the spirit and scope of the disclosure. Thus, if such modifications and variations of the embodiments fall within the scope of the appended claims and their equivalents, the disclosure also intends to encompass these changes and variations.

**Claims**

1.  An Infinite Impulse Response, IIR, filter device, comprising:

    a header data module, configured to receive a current input data value and to latch the current input data value by overwriting an earliest historical input data value, maintaining that the current input data value and two historical input data values are stored;
    a filtering module, configured to perform multi-stage filtering calculations, and comprising an intermediate data module and a calculation module; wherein

    the intermediate data module comprises a first location and a second location corresponding to each stage of filtering, and is configured to use the first location corresponding to each stage of filtering to store an output data value of that stage of filtering, and to exchange an address of the first location and an address of the second location;
    the calculation module is configured, based on determining that a current stage of filtering is triggered, to read the current input data value and two historical input data values from a specified location, to read data values from a first location and a second location corresponding to the current stage of filtering in the intermediate data module as two historical output data values, to store the two historical output data values into a tail data module as two historical input data values for a next stage of filtering, to obtain a current output data value after filtering, and to trigger the next stage of filtering;

    the tail data module, configured to store the two historical output data values read by the calculation module as two historical input data values, and upon completion of any stage of filtering, to store an output data value of that stage as a current input data value for the next stage of filtering;
    wherein, a specified location for a first stage of filtering is the header data module, and a specified location for another stage of filtering is the tail data module.

2.  The device according to claim 1, wherein the header data module comprises:

    a header data register, comprising a first header register, a second header register, and a third header register;
    a header data manager, configured to receive the current input data value, to latch a historical input data value from the first header register into the second header register or the third header register where the earliest historical input data value is stored, and to latch the current input data value into the first header register.

3.  The device according to claim 2, wherein the header data register further comprises a status register;

    wherein the header data manager is configured, after the first stage of filtering is completed, to trigger a change in a status value of the status register; wherein
    based on that the status value is a first status value, the historical input data value from the first register is latched into the second register; and
    based on that the status value is a second status value, the historical input data from the first register is latched into the third register.

4.  The device according to claim 1, wherein the intermediate data module comprises:

    an intermediate data manager, configured to store an output data value of each stage of filtering into the first location and exchange the address of the first location and the address of the second location; and
    an intermediate data memory, comprising a first address and a second address corresponding to each stage of filtering, wherein the first address and the second address are used to store corresponding data.

5.  The device according to claim 1, wherein the calculation module comprises:

a coefficient memory, configured to store coefficients corresponding respectively to a current input data value, two historical input data values, and two historical output data values, of each stage of filtering;

a data selector, configured, when the current stage of filtering is triggered, to read the current input data value and two historical input data values from the specified location, to read data values from the first location and the second location corresponding to the current stage of filtering in the intermediate data module as two historical output data values, to read coefficients corresponding respectively to the current input data value, the two historical input data values, and the two historical output data values from the coefficient memory, and to output the current input data value, the two historical input data values, and the two historical output data values, and the coefficients corresponding respectively to the current input data value, the two historical input data values, and the two historical output data values to a multiply-accumulate unit; and

the multiply-accumulate unit, configured to perform multiply-accumulate operations based on the current input data value, the two historical input data values, the two historical output data values, and the coefficients corresponding respectively to the current input data value, the two historical input data values, the two historical output data values to obtain the current output data value.

6. The device according to claim 5, wherein the calculation module further comprises an output latch, connected to the multiply-accumulate unit and configured to latch the current output data value.

7. The device according to claim 1, wherein the tail data module comprises:

   a tail data register, comprising a first tail register, a second tail register, and a third tail register; and
   a tail data manager, configured:

   during calculation of the current stage of filtering, to latch a historical output data value read by the calculation module from the first location corresponding to the current stage of filtering in the intermediate data module into the second tail register, and to latch a historical output data value read from the second location corresponding to the current stage of filtering in the intermediate data module into the third tail register; and upon completion of the current stage of filtering, to latch the output data value of the current stage of filtering into the first tail register.

8. The device according to claim 1, further comprising:

   a clock cycle counter, configured to start counting when any stage of filtering is triggered; wherein

   each time a clock cycle count value increases by one, a corresponding one of parameter sets is read, and the parameter sets comprise: the current input data value and a coefficient corresponding to the current input data value, a first historical input data value and a coefficient corresponding to the first historical input data value, a second historical input data value and a coefficient corresponding to the second historical input data value, a first historical output data value and a coefficient corresponding to the first historical output data value, and a second historical output data value and a coefficient corresponding to the second historical output data value; and the clock cycle count value is reset to zero based on determining that the current stage of filtering is completed;

   and
   a section counter, configured:

   to increase a section count value by one upon completion of any stage of filtering; and based on that the section count value reaches a set section number, to determine that all stages of filtering are completed, and to reset the section count value to zero.

9. A filtering method of an Infinite Impulse Response, IIR, filter device, comprising:

   using a header data module to receive a current input data value and latch the current input data value by overwriting an earliest historical input data value, maintaining that the current input data value and two historical input data values are stored in the header data module;
   triggering a first stage of filtering, reading the current input data value and the two historical input data values from the header data module for filtering, and reading two historical output data values from a first location and a second location corresponding to the first stage of filtering in an intermediate data module for filtering;

determining to trigger another stage of filtering, reading a current input data value and two historical input data values from a tail data module for filtering, reading two historical output data values from a first location and a second location corresponding to that stage of filtering in the intermediate data module for filtering, and storing the two historical output data values into a tail storage module as two historical input data values for a next stage of filtering; and

based on determining that any stage of filtering is completed, using the tail data module to store an output data value of that stage of filtering as a current input data value for the next stage of filtering; and triggering the next stage of filtering until filtering is completed.

10. The method according to claim 9, further comprising:

starting counting when any stage of filtering is triggered;

reading a corresponding one of parameter sets each time a clock cycle count value increases by one, wherein the parameter sets comprises: the current input data value and a coefficient corresponding to the current input data value, a first historical input data value and a coefficient corresponding to the first historical input data value, a second historical input data value and a coefficient corresponding to the second historical input data value, a first historical output data value and a coefficient corresponding to the first historical output data value, and a second historical output data value and a coefficient corresponding to the second historical output data value;

resetting the clock cycle count value to zero based on determining that the current stage of filtering is completed;

increasing a section count value by one upon completion of any stage of filtering; and

based on that the section count value reaches a set section number, determining that all stages of filtering are completed, and resetting the section count value to zero.

11. The method according to claim 9, wherein the corresponding one of parameter sets is read in a following order:

a second historical input data value and a coefficient corresponding to the second historical input data value;

the current input data value and a coefficient corresponding to the current input data value;

a first historical output data value and a coefficient corresponding to the first historical output data value;

a first historical input data value and a coefficient corresponding to the first historical input data value; and

a second historical output data value and a coefficient corresponding to the second historical output data value;

wherein, the first historical input data value precedes the second historical input data value, and the first historical output data value precedes the second historical output data value.

FIG. 1

FIG. 2

FIG. 3

FIG. 4

Input
x → Header data manager 101 → rx0
rx1
rx2
z1_addr

Header data register 102

Section counter 40 → Section number

Clock cycle counter 50 → Clock cycle number

Intermediate data manager 2011 → y1,y2 → Data selector 2021 → x0,x1,x2,y1,y2 → Multiply-accumulate unit 2023 → y_next → Output latch 2024 → Output y

Intermediate data memory 2012

Coefficient register 2022 → b0,b1,b2,a1,a2

Tail data manager 301 → ry0
ry1
ry2

x0, x1 and x2 for the next stage of filter

Tail data register 302

FIG. 5A

FIG. 5B

Start

Input x0

If z1_addr is 0, latch the value in rx0 into rx1

If z1_addr is 1, latch the value in rx0 into rx2

Latch x0 into rx0

Toggle the value of z1_addr

FIG. 6

| Section 1 | y1 |
|---|---|
| | y2 |
| Section 2 | y1 |
| | y2 |
| Section 3 | y1 |
| | y2 |
| ... | ... |
| Section N | y1 |
| | y2 |

Original arrangement in RAM

| Section 1 | y2 |
|---|---|
| | y1 |
| Section 2 | y2 |
| | y1 |
| Section 3 | y2 |
| | y1 |
| ... | ... |
| Section N | y1 |
| | y2 |

Arrangement in RAM after completing calculation based on input of the first value

| Section 1 | y1 |
|---|---|
| | y2 |
| Section 2 | y1 |
| | y2 |
| Section 3 | y1 |
| | y2 |
| ... | ... |
| Section N | y1 |
| | y2 |

Arrangement in RAM after completing calculation based on input of the second value

FIG. 7

Start from calculation for
the M-th section

Read x0, x1, x2 for this
section, that is stored in
ry0, ry1, and ry2 from the
previous section

Read y1 and y2 for this
section

Latch y1 into ry1, and
latch y2 into ry2

Calculation for the M-th
section ends

Lacth y_next into ry0

Start from calculation for
the (M+1)-th section

Read x0, x1, x2 for this
section, that is stored in
ry0, ry1, and ry2 from the
previous section

Read y1 and y2 for this
section

Latch y1 into ry1, and
latch y2 into ry2

Calculation for the
(M+1)-th section ends

Lacth y_next into ry0

FIG. 8

Start

Input a batch of data

Start the section counter and initialize the section counter

Start the clock cycle counter and initialize the clock counter

Other components operate according to the count value of the section counter and the count value of the clock cycle counter

The clock cycle count value increases by 1

The clock cycle count ≥ 5

No

Yes

The section count value increases by 1

The section count value ≥ N

No

Yes

Calculation ends

FIG. 9

Use a header data module to receive a current input data value and latch the current input data value by overwriting an earliest historical input data value, maintaining that the current input data value and two historical input data values are stored in the header data module — 101

Trigger a first stage of filtering, read the current input data value and the two historical input data values from the header data module, and read two historical output data values from a first location and a second location corresponding to the first stage of filtering in the intermediate data module for filtering — 102

Determine to trigger another stage of filtering of filtering, read a current input data value and two historical input data values from a tail data module, read two historical output data values from a first location and a second location corresponding to that stage of filtering in the intermediate data module for filtering, and store the two historical input data values into the tail storage module as two historical input data values for a next stage of filtering — 103

Based on determining that any stage of filtering is completed, use the tail data module to store an output data value of that stage of filtering as a current input data value for the next stage of filtering; and trigger the next stage of filtering until filtering is completed — 104

FIG. 10

```
┌─────────────────────────┐              ┌─────────────────────────┐
│  Start from calculation │              │  Start from calculation │
│  for the M-th section   │              │  for the (M+1)-th section│
└─────────────────────────┘              └─────────────────────────┘
            │                                        │
            ▼                                        ▼
┌─────────────────────────┐              ┌─────────────────────────┐
│ Initialize multiply-    │              │ Initialize multiply-    │
│ accumulate unit (MAC)   │              │ accumulate unit (MAC)   │
└─────────────────────────┘              └─────────────────────────┘
            │                                        │
            ▼                                        ▼
┌─────────────────────────┐              ┌─────────────────────────┐
│  Read x0, x1, x2 for    │              │  Read x0, x1, x2 for    │
│  this section, that is  │              │  this section, that is  │
│  stored in ry0, ry1,    │              │  stored in ry0, ry1,    │
│  and ry2 from the       │              │  and ry2 from the       │
│  previous section       │              │  previous section       │
└─────────────────────────┘              └─────────────────────────┘
            │                                        │
            ▼                                        ▼
┌─────────────────────────┐              ┌─────────────────────────┐
│  Read y1 and y2 for     │              │  Read y1 and y2 for     │
│  this section           │              │  this section           │
└─────────────────────────┘              └─────────────────────────┘
            │                                        │
            ▼                                        ▼
┌─────────────────────────┐              ┌─────────────────────────┐
│  Latch y1 into ry1,     │              │  Latch y1 into ry1,     │
│  and latch y2 into ry2  │              │  and latch y2 into ry2  │
└─────────────────────────┘              └─────────────────────────┘
            │                                        │
            ▼                                        ▼
┌─────────────────────────┐              ┌─────────────────────────┐
│  Calculation for the    │              │  Calculation for the    │
│  M-th section ends      │              │  (M+1)-th section ends  │
└─────────────────────────┘              └─────────────────────────┘
            │                                        │
            ▼                                        ▼
┌─────────────────────────┐              ┌─────────────────────────┐
│  Lacth y_next into ry0  │              │  Lacth y_next into ry0  │
└─────────────────────────┘              └─────────────────────────┘
```

FIG. 11

Start

Input a batch of data

Start the section counter and initialize the section counter, and initialize the multiply-accumulate unit (MAC)

Start the clock cycle counter and initialize the clock counter

Other components operate according to the count value of the section counter and the count value of the clock cycle counter

The clock cycle count value increases by 1

The clock cycle count ≥ 5

No

Yes

The section count value increases by 1

The section count value ≥ N

No

Yes

Calculation ends

FIG. 12

## INTERNATIONAL SEARCH REPORT

| International application No. |
| --- |
| **PCT/CN2024/114062** |

**A. CLASSIFICATION OF SUBJECT MATTER**

H03H17/02(2006.01)i

According to International Patent Classification (IPC) or to both national classification and IPC

**B. FIELDS SEARCHED**

Minimum documentation searched (classification system followed by classification symbols)

IPC:H03H

Documentation searched other than minimum documentation to the extent that such documents are included in the fields searched

Electronic data base consulted during the international search (name of data base and, where practicable, search terms used)

CNABS, CNTXT, DWPI, VEN, USTXT, WOTXT, EPTXT, CNKI, IEEE: 滤波器, 输入数据, 历史数据, 交换, 地址, 存储, 输出数据, filter, input data, historical data, exchange, address, storage, output data

**C. DOCUMENTS CONSIDERED TO BE RELEVANT**

| Category* | Citation of document, with indication, where appropriate, of the relevant passages | Relevant to claim No. |
| --- | --- | --- |
| A | CN 106533392 A (HANGZHOU SILAN MICROELECTRONICS CO., LTD.) 22 March 2017 (2017-03-22)<br>description, paragraphs 2-70, and figures 1-4 | 1-11 |
| A | CN 113258902 A (RIVAI TECHNOLOGIES (SHENZHEN) CO., LTD.) 13 August 2021 (2021-08-13)<br>description, paragraphs 113-139, and figures 1-5 | 1-11 |
| A | CN 110957995 A (SICHUAN HUIYUAN OPTICAL COMMUNICATION CO., LTD.) 03 April 2020 (2020-04-03)<br>entire document | 1-11 |
| A | CN 107357745 A (FREESCALE SEMICONDUCTOR INC.) 17 November 2017 (2017-11-17)<br>entire document | 1-11 |
| A | US 6175849 B1 (LUCENT TECHNOLOGIES INC.) 16 January 2001 (2001-01-16)<br>entire document | 1-11 |
| A | US 5170369 A (E-MU SYSTEMS INC.) 08 December 1992 (1992-12-08)<br>entire document | 1-11 |

☐ Further documents are listed in the continuation of Box C.  ☑ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **05 November 2024** | **16 November 2024** |

| Name and mailing address of the ISA/CN | Authorized officer |
| --- | --- |
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2024/114062**

| Patent document cited in search report | | | Publication date (day/month/year) | Patent family member(s) | | | Publication date (day/month/year) |
|---|---|---|---|---|---|---|---|
| CN | 106533392 | A | 22 March 2017 | CN | 106533392 | B | 08 September 2023 |
| CN | 113258902 | A | 13 August 2021 | CN | 113258902 | B | 22 February 2022 |
| CN | 110957995 | A | 03 April 2020 | CN | 110957995 | B | 30 June 2023 |
| CN | 107357745 | A | 17 November 2017 | US | 2017322895 | A1 | 09 November 2017 |
| | | | | US | 9965416 | B2 | 08 May 2018 |
| US | 6175849 | B1 | 16 January 2001 | None | | | |
| US | 5170369 | A | 08 December 1992 | None | | | |

Form PCT/ISA/210 (patent family annex) (July 2022)

**REFERENCES CITED IN THE DESCRIPTION**

**Patent documents cited in the description**

- CN 202311425949